# FASCICULE DE BREVET EUROPEEN

(11) **EP 0 426 250 B1**
(45) Date de publication et mention de la délivrance du brevet: **05.04.1995**
(21) Numéro de dépôt: 90202859.6
(22) Date de dépôt: 29.10.1990
(51) Int. Cl.: H01L 21/336

(54) **Procédé pour fabriquer un dispositif à transistors MIS ayant une grille débordant sur les portions des régions de source et de drain faiblement dopées**
Verfahren zur Herstellung eines MIS-Transistor-Bauelementes mit einem Gitter, welches über geringdotierte Teile der Source- und Drain-Gebiete herausragt
Process for manufacturing a device having MIS transistors with a gate overlapping the lightly-doped source and drain regions

(30) Priorité: 03.11.1989 FR 8914434
(43) Date de publication de la demande: 08.05.1991
(73) Titulaire: Philips Electronics N.V., 5621 BA Eindhoven (NL)
(72) Inventeur: Verhaar, Robertus, NL-5656 AA Eindhoven (NL)
(74) Mandataire: Charpail, François

(56) Documents cités:
- IEEE TRANSACTIONS ON ELECTRON DEVICES, vol. 35, no. 12, décembre 1988, pages 2088-2093, IEEE, New York, US; R. IZAWA et al.: "Impact of the gate-drain overlapped device (GOLD) for deep submicrometer VLSI"

## Description

La présente invention concerne un procédé pour fabriquer un dispositif semiconducteur comportant au moins un transistor de type MIS ayant une région de drain et une région de source comportant chacune une portion faiblement dopée et une portion fortement dopée, légèrement décalée latéralement par rapport à la précédente portion, ainsi qu'une électrode de grille recouvrant la portion faiblement dopée et s'étendant latéralement vers la portion fortement dopée, procédé dans lequel, sur un corps semiconducteur recouvert d'une couche isolante de grille, on réalise successivement :
- un dépôt d'une première couche polycristalline, rendue conductrice par dopage,
- la formation d'une première couche isolante, mince, en vue de son utilisation ultérieure en tant qu'arrêt de décapage,
- un dépôt d'une deuxième couche polycristalline conductrice plus épaisse que la première couche polycristalline,
- la formation d'une deuxième couche isolante plus épaisse que la première couche isolante,
- la définition d'îlots de grille par décapage localisé de la deuxième couche isolante et de la deuxième couche polycristalline, en dehors desdits îlots,
- l'implantation ionique des portions faiblement dopées des régions de source et de drain en utilisant les îlots de grille comme masque d'implantation,
- la formation d'espaceurs isolants sur les bords des îlots de grille par un dépôt d'une troisième couche isolante suivi d'un décapage anisotrope de l'essentiel de cette couche, lesdits espaceurs isolants délimitant à leur pourtour, des îlots de grille élargis,
- l'enlèvement par décapage sélectif du matériau polycristallin exposé en dehors desdits îlots de grille élargis,
- l'implantation ionique des portions fortement dopées des régions de source et de drain, en utilisant lesdits îlots de grille élargis comme masque d'implantation, puis,
- les opérations de finition du dispositif nécessaires pour les prises de contact et l'interconnexion avec les régions actives et avec les grilles des transistors.

Un transistor MIS à grille débordante (aussi désignée par grille en forme de T inversé) est connu de la publication "Impact of the Gate-Drain Overlapped Device (GOLD) for Deep Submicrometer VLSI" de R. IZAWA, T. KURE et E. TAKEDA, dans la revue IEEE Transactions on Electron Devices V.35, N°12, décembre 1988.

Un procédé pour fabriquer un transistor de ce type, destiné à la constitution de circuits intégrés à très grande densité d'intégration, est également indiqué dans la même publication.

Les auteurs ont montré que la limitation des performances des transistors MIS de dimensions submicroniques vis-à-vis de la tension de claquage de drain, de l'émission de porteurs chauds, et/ou de la transconductance insuffisante, pouvait être repoussée par l'utilisation d'une électrode de grille recouvrant les portions faiblement dopées des régions de source et de drain, et s'étendant en direction des portions fortement dopées de ces régions, sur une distance qui doit être optimisée.

La grille des transistors, est réalisée à partir de deux couches distinctes de silicium polycristallin de manière à obtenir la forme caractéristique d'un T inversé. Selon le procédé connu, ces deux couches polycristallines sont séparées par une couche d'oxyde excessivemeent mince, de l'ordre de 0,5 à 1nm d'épaisseur, de telle sorte que cette couche puisse servir de repère pour l'arrêt de décapage de la deuxième couche polycristalline lors de la formation des îlots de grille, mais assure néanmoins une conduction électrique suffisante entre la première et la deuxième couche polycristalline, au sein de l'îlot de grille élargi du dispositif final.

Un inconvénient inhérent au procédé connu réside dans la difficulté d'obtenir de manière reproductible une couche d'oxyde d'épaisseur aussi faible devant réaliser un compromis très étroit entre l'éfficacité de sa fonction d'arrêt de décapage et une conduction électrique de cette couche assez élevée pour ne pas induire d'effets parasites dans le fonctionnement des transistors et en particulier dans l'efficacité de la transmission des tensions vers la partie inférieure des grilles, dans un large spectre de fréquences.

L'invention propose une modification du procédé connu en vue d'éviter l'inconvénient mentionné. Elle repose sur l'idée que la conduction électrique entre la première et la deuxième couche polycristalline, au sein de l'îlot de grille élargi du dispositif final, pourrait être obtenue par des moyens indépendants de l'épaisseur de la couche dite première couche isolante et qu'ainsi on soit libre de choisir pour cette couche une épaisseur plus substantielle, donc plus aisée à obtenir de manière reproductible et également moins critique à utiliser en tant qu'arrêt de décapage.

En effet, selon la presente invention, un procédé pour fabriquer un dispositif semiconducteur, tel que défini dans le paragraphe introductif, est caractérisé en ce qu'on utilise une première couche isolante ayant une épaisseur plus élevée que celle qui permet une conduction électrique entre les première et deuxième couches polycristallines, en ce qu'après avoir réalisé l'implantation ionique des portions faiblement dopées des régions de source et de drain, on retire par décapage les parties de la première couche isolante situées en dehors des îlots de grille, et en ce qu'on dépose ensuite sur l'ensemble une troisième couche polycristalline rendue conductrice par dopage, avant de former les espaceurs isolants.

Selon le procédé de l'invention, la continuité électrique dans les îlots de grille élargis est assurée par des petites portions de la troisième couche polycristalline, qui subsistent à la périphérie desdits îlots et qui sont en contact, d'une part avec la tranche de la partie restante de deuxième couche polycristalline des îlots, et d'autre part avec la partie de première couche polycristalline, située sous les espaceurs isolants. Il n'est donc plus nécessaire de choisir une première couche isolante d'épaisseur si faible que cette couche soit conductrice et on aboutit à un procédé bien reproductible.

Un autre avantage du procédé selon l'invention est que la couche isolante de grille se trouve protégée par au moins une couche polycristalline durant la plus grande partie du procédé d'élaboration du dispositif.

Avantageusement, on utilise une première couche isolante dont l'épaisseur est supérieure à 5nm et de préférence inférieure à 20nm, par exemple de 10nm, et une deuxième couche isolante dont l'épaisseur est supérieure à 40nm. Ainsi, on peut retirer la première couche isolante en dehors des îlots de grille, sans avoir recours à un masque de décapage, et tout en conservant une portion de l'épaisseur de la deuxième couche isolante au-dessus des îlots de grille puisqu'elle est nettement plus épaisse, et peut être préservée en limitant la durée du décapage.

La portion de deuxième couche isolante qui subsiste alors est utilisée ultérieurement en tant qu'arrêt de décapage lorsqu'on retire l'essentiel de la troisième couche polycristalline.

Le procédé selon l'invention a donc l'avantage de rester simple à mettre en oeuvre même si toutes les couches isolantes sont réalisées en un même matériau, par exemple de l'oxyde de silicium.

Selon une variante du procédé de l'invention, la couche isolante de grille ainsi que les première et troisième couches isolantes sont réalisées en oxyde de silicium, tandis que la deuxième couche isolante est composée d'une couche d'oxyde de silicium recouverte d'une couche de nitrure de silicium. On peut alors retirer la première couche isolante en dehors des îlots de grille, de manière sélective et préserver de manière sûre l'intégralité de la deuxième couche isolante au-dessus des îlots de grille.

Le procédé selon l'invention permet de pratiquer les prises de contact sur le dispositif par ouvertures de fenêtres de contact localisées au moyen d'un masque photosensible, selon les techniques habituelles bien connues.

Toutefois, il est également souhaitable de pouvoir établir des aires de contact métalliques sur le dispositif par une technique d'auto-alignement utilisant entre-autres un siliciure métallique, qui ne nécessiterait pas de masque pour la réalisation des fenêtre de contact.

Dans ce cas, il est possible d'obtenir une réduction sensible des dimensions des transistors et d'augmenter la densité d'intégration des dispositifs à nombre très élevé d'éléments.

Cette possibilité est obtenue selon un mode particulier de mise en oeuvre de l'invention caractérisé en ce qu'après la formation des espaceurs isolants, l'enlèvement par décapage sélectif du matériau polycristallin non protégé est prolongé d'une durée déterminée dans des conditions de décapage isotrope, de manière à former des gorges dans les parties non protégées des première et troisième couches polycristallines, et en ce que ces gorges sont ensuite comblées avec un matériau isolant particulier ayant des propriétés sélectives de décapage vis-à-vis des autres couches isolantes déjà existantes sur le dispositif, par les opérations successives de dépôt d'une couche d'un tel matériau et de décapage anisotrope de l'essentiel de cette couche qui est situé en dehors desdites gorges. Par exemple, cette opération de remplissage des gorges peut être réalisée avec du nitrure de silicium.

Des fenêtres de contact peuvent alors être ouvertes sélectivement sur les portions du dispositif qui présentent de l'oxyde de silicium en surface, tandis qu'en bordure de ces régions subsistent des cordons dudit matériau isolant particulier qui réalisent un isolement latéral nécessaire entre les plages de contact formées sur les régions actives.

La description qui va suivre en regard des dessins annexés décrivant des exemples non limitatifs, fera bien comprendre comment l'invention peut être réalisée.
Les figures 1 à 5 montrent des vues schématiques, en coupe, d'une portion de dispositif MIS, illustrant différentes étapes du procédé selon l'invention dans un premier exemple de mise en oeuvre,
la figure 6 est une vue analogue à la figure 2, illustrant une variante de réalisation de l'invention, et
les figures 7 à 9 présentent des vues schématiques, en coupe, relatives à un autre exemple de mise en oeuvre de l'invention.

Pour plus de clarté des figures, les proportions des dimensions ne sont pas respectées et en particulier certaines dimensions dans le sens de l'épaisseur ont été notablement augmentées. En général, les éléments constitutifs qui sont homologues sur les différentes figures sont affectés de signes de référence identiques.

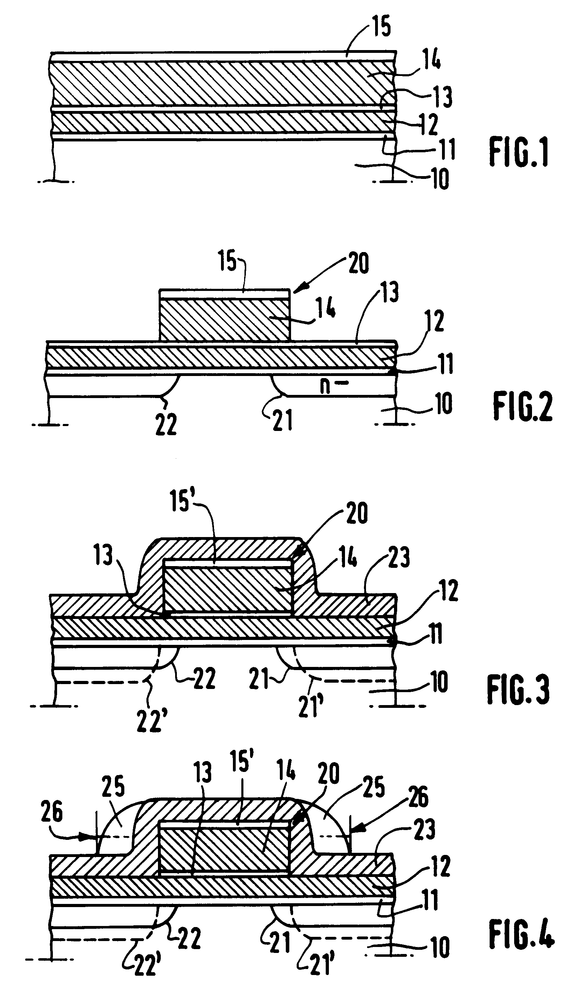

La figure 1 représente une portion superficielle d'un corps semiconducteur 10, par exemple en silicium de type p, qui est surmontée d'une couche isolante de grille 11, de préférence en oxyde de silicium, d'une épaisseur voisine de 20nm. Une première couche polycristalline 12 de 50nm d'épaisseur a été déposée ensuite sur la couche isolante de grille 11, couche polycristalline 12 qui a été rendue conductrice par dopage à concentration élevée selon une technique habituelle notamment par dopage pendant le dépôt.

A la surface de la première couche polycristalline 12 a été formée ensuite une première couche isolante 13, mince, en oxyde de silicium, d'une épaisseur de 10nm qui est destinée à servir ultérieurement d'arrêt de décapage. Une deuxième couche polycristalline 14 a été ensuite déposée sur l'ensemble de la surface, couche qui est également rendue conductrice par dopage. La deuxième couche polycristalline 14 est plus épaisse que la première couche polycristalline, par exemple d'une épaisseur de 200nm. On forme ensuite sur l'ensemble une deuxième couche isolante 15 qui est plus épaisse que la première couche isolante 13, soit supérieure à 40nm et par exemple de 60nm. La deuxième couche isolante 15 peut être obtenue par oxydation thermique de la deuxième couche polycristalline ou encore par dépôt chimique en phase vapeur d'une couche d'oxyde de silicium.

Comme indiqué à la figure 2, on réalise ensuite un décapage localisé de la deuxième couche isolante 15 et de la deuxième couche polycristalline 14 de manière à former des îlots de grille 20, en utilisant les techniques habituelles de masquage et de gravure. Il est à noter à ce propos que l'invention vise plus particulièrement la fabrication de transistors MIS dont la dimension latérale des îlots de grille 20 est voisine ou inférieure à 1»m.

On réalise ensuite par implantation ionique un dopage à faible concentration de type n pour réaliser des portions faiblement dopées 21 et 22 des régions de source et de drain, implantation qui est réalisée à travers la première couche isolante 13, la première couche polycristalline 12 et la couche isolante de grille 11, et en utilisant l'îlot de grille 20 en tant que masque de protection contre l'implantation. Cette implantation est réalisée par exemple avec des ions de phosphore à une dose de 4.10. ¹³at/cm² et sous une énergie de 70 keV.

On retire ensuite par décapage des parties de la première couche isolante 13 qui sont situées en dehors des îlots de grille 20, ainsi que cela est représenté à la figure 3, et on dépose alors sur l'ensemble ainsi formé une troisième couche polycristalline 23 qui est rendue conductrice par dopage. Avantageusement la troisième couche polycristalline 23 a une épaisseur comprise entre 30 et 100nm et de préférence voisine de 50nm.

Conformément au procédé selon l'invention, et ainsi qu'on le verra dans la suite de cet exposé, la continuité électrique au sein de l'îlot de grille entre la première couche polycristalline 12 et la deuxième couche polycristalline 14 n'est pas réalisée par la conduction à travers la première couche isolante 13, mais au contraire, au moyen de la troisième couche polycristalline 23. L'épaisseur de la première couche isolante 13 peut donc être choisie plus élevée que celle qui permet la conduction électrique et avantageusement de l'ordre de 10nm par exemple. Par rapport au procédé connu, cette première couche isolante 13 assure donc plus efficacement son rôle d'arrêt de décapage lors de la formation des îlots de grille 20 à la fin du décapage de la deuxième couche polycristalline 14, et elle est obtenue de manière moins critique.

Le retrait de la première couche isolante 13 en dehors des îlots de grille 20 peut être effectué sans avoir recours à un masque du fait que la deuxième couche isolante 15 est notablement plus épaisse que la première couche isolante 13 et qu'un décapage à durée contrôlée permet de retirer complètement la première couche isolante 13 en dehors des îlots de grille 20 tout en laissant subsister une portion 15′ de la deuxième couche isolante 15, à la surface des îlots de grille 20.

De manière à ce que la troisième couche polycristalline 23 recouvre convenablement les bords des îlots de grille 20 on utilise à cet effet une méthode de dépôt assurant un bon recouvrement de surface y compris les reliefs topographiques, par exemple un dépôt chimique en phase vapeur à pression réduite (LPCVD).

Compte tenu de l'élargissement des îlots de grille 20 dû à l'épaisseur de la troisième couche polycristalline 23, le procédé selon l'invention offre une possibilité très utile d'effectuer à ce stade et par implantation ionique, un dopage complémentaire des zones de source et de drain du transistor MIS tel que représenté à la figure 3 par les lignes en pointillé 21′ et 22′, dopage qui est plus élevé que le dopage des portions 21 et 22 mais inférieur aux portions fortement dopées n+ qui seront réalisées ultérieurement. Cette opération peut être effectuée avec des ions de phosphore, à une dose de 2.10.¹⁴at/cm² et une énergie de 70 keV.

La figure 4 représente le résultat des étapes suivantes du procédé qui consistent en la formation d'espaceurs isolants 25 sur les bords des îlots de grille 20 par un dépôt d'une troisième couche isolante relativement épaisse (par exemple 200nm), en oxyde de silicium, suivie d'un décapage anisotrope de l'essentiel de cette couche, technique connue en soi qu'il n'est pas nécessaire de décrire ici en détail. Les espaceurs isolants 25 délimitent à leur pourtour des îlots de grille élargis 26.

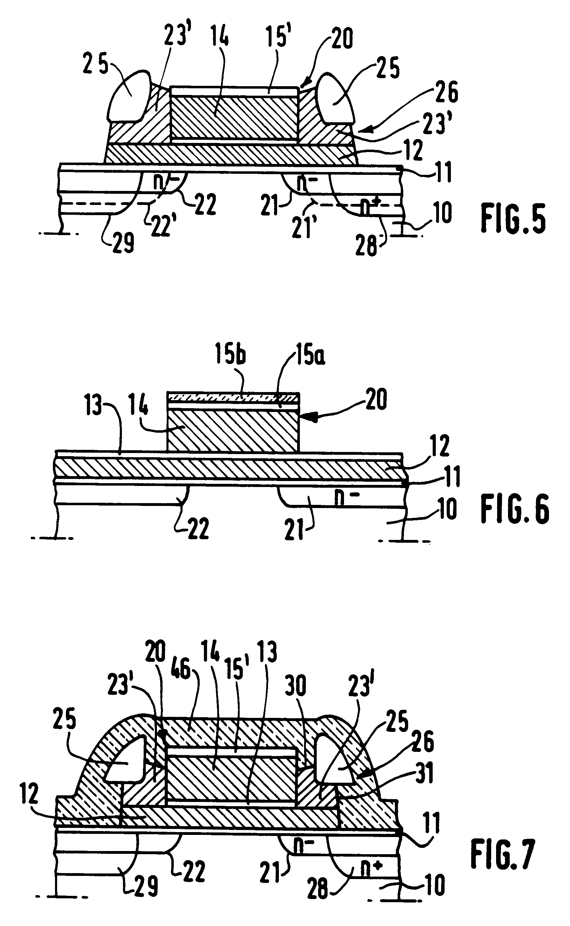

L'opération suivante, schématisée à la figure 5, consiste à enlever par décapage sélectif et anisotrope le matériau polycristallin exposé en surface c'est-à-dire les première et troisième couche polycristallines à l'extérieur des îlots de grille élargis 26 ainsi que la portion de troisième couche polycristalline située au-dessus des îlots de grille 20. Ce décapage peut être réalisé en utilisant un plasma riche en chlore. Au cours de cette opération de décapage qui peut être effectuée sans masque, la couche isolante de grille 11 les espaceurs isolants 25 et la portion d'épaisseur restante de deuxième couche isolante 15′ éléments qui sont en oxyde de silicium, fournissent un arrêt de décapage à leurs emplacements respectifs. De la troisième couche polycristalline 23, il ne subsiste alors que de petites portions 23′ en forme de L, situées à la périphérie des îlots de grille et qui sont en contact électrique d'une part avec la tranche de la partie restante de deuxième couche polycristalline 14 des îlots, et d'autre part en contact avec la partie de première couche polycristalline 12 qui est située sous les espaceurs isolants 25. On procède ensuite, par implantation ionique, au dopage des régions fortement dopées 28 et 29 des régions de source et de drain du transistor MIS, de type n+, en utilisant les îlots de grille élargis 26 comme masque d'implantation. Cette implantation peut être réalisée avec de l'arsenic, à une dose de 2.10.¹⁵at/cm² et une énergie de 100keV. La figure 5 représente ainsi le dispositif tel qu'il apparaît à ce stade des opérations qui précède la finition du dispositif notamment par la prise des contacts avec les régions actives du dispositif (source, drain et grille). On notera sur cette figure que les portions des régions de drain et de source de différents dopages, 21, 21′, 28 - 22, 22′, 29 se présentent d'une manière étagée latéralement dans l'ordre qui convient pour favoriser une tension de claquage élevée de la diode drain/substrat, pour réduire l'émission de porteurs de charge à haute énergie au passage de la jonction et permettant ainsi d'améliorer la stabilité à long terme des caractéristiques électriques du dispositif.

A partir de l'étape du procédé représentée à la figure 5 le dispositif peut être terminé par ouverture de fenêtres de contact localisées au moyen d'un masque photosensible selon des techniques habituelles bien connues qu'il n'est pas utile de décrire plus en détail ici.

La figure 6 représente une variante du procédé qui vient d'être décrit dans laquelle la deuxième couche isolante est composée d'une couche d'oxyde de silicium 15a recouverte d'une couche de nitrure de silicium 15b. Par rapport au procédé décrit précédemment en relation avec la figure 1, la variante maintenant décrite consiste donc à ajouter la couche de nitrure de silicium 15b dont l'épaisseur peut être choisie par exemple voisine de 50nm. La figure 6 qui représente le dispositif à un stade équivalent de celui de la figure 2 dans le procédé précédemment décrit, montre que les portions de première couche isolante 13 en oxyde de silicium, peuvent être décapées sélectivement par rapport à la couche de nitrure de silicium 15b qui subsiste au-dessus de l'îlot de grille 20. Ce décapage peut être obtenu par voie humide dans une solution tamponée d'acide fluorhydrique-fluorure d'ammonium. Grâce à cette sélectivité de décapage, la deuxième couche isolante 15a, 15b située au-dessus des îlots de grille 20 peut être préservée intégralement et la partie 15a de la deuxième couche isolante réalisée en oxyde de silicium peut être alors utilisée de manière sûre en tant qu'arrêt de décapage pour le retrait sélectif des couches polycristallines après formation des espaceurs isolants.

Les figures 7 à 9 représentent un autre mode de mise en oeuvre de l'invention permettant de procurer des aires métalliques de contact sur le dispositif par une technique d'auto-alignement notamment par utilisation de siliciure métallique.

Les premières étapes du procédé telles que décrites à propos des figures 1 à 5 demeurent identiques.

Ainsi que cela est représenté à la figure 7, l'enlèvement par décapage sélectif du matériau polycristallin non protégé est prolongé durant une durée déterminée et dans des conditions de décapage isotrope de manière à former des gorges 30 dans la troisième couche polycristalline entre les espaceurs 25 et la partie restante de deuxième couche isolante 15′ ainsi que des gorges 31 dans les première et troisième couches polycristallines à la phériphérie des îlots de grille élargis 26, en dessous des espaceurs isolants 25. De préférence le décapage des matériaux polycristallins est opéré en deux étapes la première par décapage RIE dans un plasma à base de chlore pour l'enlèvement du polycristal sans formation de gorge et une seconde étape par décapage isotrope, soit par voie sèche dans un plasma de fluor soit par voie humide par exemple dans une solution d'acide fluorhydrique-acide nitrique. Il est à noter que la formation des gorges 31 joue un rôle sur l'extension de l'électrode de grille du transistor MIS en combinaison avec l'extension latérale du dopage n+ des régions de source et de drain 28-29 et peut permettre d'obtenir une distribution optimale du champ électrique à la jonction de drain favorisant une tension de claquage élevée de cette jonction.

Après la formation par implantation ionique des portions fortement dopées 28 et 29 des régions de source et de drain en utilisant les îlots de grille élargis 26 en tant que masque d'implantation qui peuvent être obtenues de même manière qu'indiqué précédemment, on recouvre l'ensemble de la structure par une couche de nitrure de silicium 46 d'une épaisseur suffisante pour remplir au moins les gorges 30 et 31. Le procédé utilisé pour déposer la couche de nitrure de silicium 46 doit être choisi pour procurer un bon recouvrement du relief topographique, par exemple le procédé LPCVD, de manière à combler les gorges 30 et 31. A titre d'exemple la couche de nitrure de silicium 46 est déposée avec une épaisseur moyenne de 300nm.

Au lieu de nitrure de silicium, d'autres matériaux isolants peuvent aussi être utilisés pour constituer la couche 46. Le seul point important est que le matériau isolant choisi pour ce faire, possède des propriétés de sélectivité au décapage telles que la couche 46 reste présente lorsque l'oxyde de silicium sera décapé à l'étape suivante du procédé.

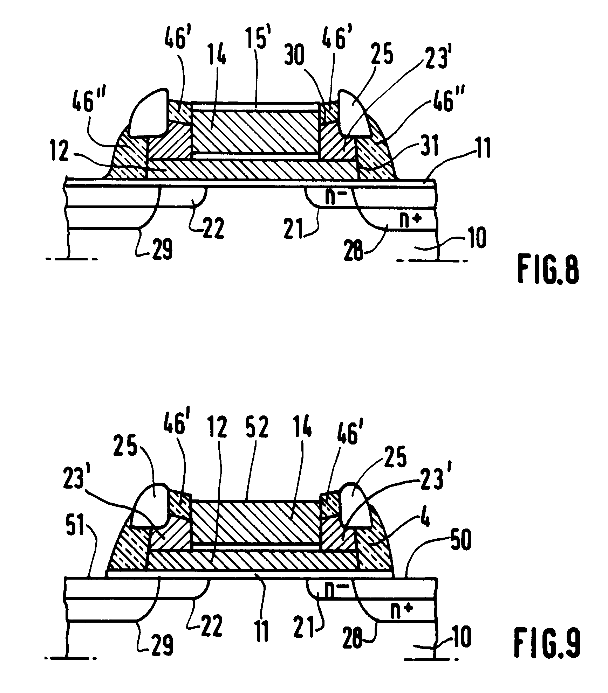

On retire ensuite, comme indiqué sur la figure 8, l'essentiel de la couche de nitrure de silicium 46 en ne laissant subsister que les portions 46′, 46˝ comblant les gorges 30 et 31, respectivement. Cette opération de retrait du nitrure de silicium est apparentée à celle qui est utilisée pour la formation d'espaceurs 26 en oxyde de silicium. Elle peut être réalisée par décapage par ions réactifs dans un plasma à base de chlore, qui est très sélectif par rapport à l'oxyde de silicium.

Dans cette opération la couche isolante de grille 11, les espaceurs isolants 25 et les portions de deuxième couche isolante 45 sur des îlots de grille 20, tous trois en oxyde de silicium, constituent respectivement un arrêt de décapage dans les zones protégées respectivement par ces couches.

Il est maintenant possible de retirer par décapage sélectif les portions exposées de la couche isolante de grille 11 en oxyde de silicium et de deuxième couche isolante 45 recouvrant les îlots de grille 20, sans utiliser de masque. L'isolement électrique nécessaire entre les différentes régions actives du transistor : source, drain, grille est réalisé par les portions 46′, 46˝ conservées de la couche de nitrure de silicium 46 qui substitent après ce décapage sélectif des régions couvertes par de l'oxyde. Tel que cela est représenté à la figure 9, il est possible en limitant le temps de décapage de l'oxyde de silicium de maintenir une portion suffisante des espaceurs isolants 25 assurant ainsi un isolement des portions de troisième couche polycristalline 23′ entre les portions 46′ et 46˝ de la couche de nitrure de silicium 46. Les zones de contact de source 50, de drain 51 et de grille 52 sont maintenant découvertes et disponibles pour réaliser selon une technique connue en soi des aires de contact métalliques sur le dispositif, de manière auto-alignée, par exemple en utilisant un siliciure tel que le siliciure de titane. De manière à accroître la densité d'intégration, il peut être nécessaire de prévoir des plots de contact sur les couches de siliciure de source et de drain, qui débordent aussi partiellement sur l'îlot de grille 20 mais sans y faire contact.

Dans ce cas, le contact avec l'îlot de grille 20 est réalisé à un autre emplacement, éloigné du plan de coupe des figures.

Cette disposition (non représentée sur les dessins) peut également être obtenue avec le procédé conforme à l'invention y compris dans sa mise en oeuvre utilisant des aires de contact auto-alignées recouvertes d'un siliciure métallique.

Il suffit pour cela de rendre la deuxième couche isolante 15 nettement plus épaisse à certains emplacement localisés devant être protégés d'un contact métallique.

Cela est aisément obtenu lorsqu'on dépose la deuxième couche isolante 15 en deux étapes : une première étape de dépôt d'une couche de forte épaisseur, par exemple 250nm d'oxyde de silicium, que l'on conserve uniquement aux emplacements à protéger, par décapage localisé, puis une seconde étape de dépôt d'une couche d'oxyde de silicium de 60nm d'épaisseur, recouvrant l'ensemble du dispositif.

En limitant à une valeur convenable la durée de décapage de la deuxième couche isolante 15, à l'étape du procédé précédemment décrite en relation avec la figure 9, il est facile d'obtenir que certaines portions d'îlot de grille 20 restent protégées par de l'oxyde (où la première couche isolante a été prévue plus épaisse) tandis que d'autres portions, non protégées, sont dénudées et donc disponibles pour la prise de contact par siliciure métallique.

## Revendications

1. Procédé pour fabriquer un dispositif semiconducteur comportant au moins un transistor de type MIS ayant une région de drain et une région de source comportant chacune une portion faiblement dopée (21, 22) et une portion fortement dopée (28, 29), légèrement décalée latéralement par rapport à la précédente portion, ainsi qu'une électrode de grille (12, 14) recouvrant la portion faiblement dopée et s'étendant latéralement vers la portion fortement dopée, procédé dans lequel, sur un corps semiconducteur (10) recouvert d'une couche isolante de grille (11), on réalise successivement :
- un dépôt d'une première couche polycristalline (12), rendue conductrice par dopage,
- la formation d'une première couche isolante (13), mince, en vue de son utilisation ultérieure en tant qu'arrêt de décapage,
- un dépôt d'une deuxième couche polycristalline (14) conductrice plus épaisse que la première couche polycristalline, la première couche isolante (13) ayant une épaisseur plus élevée que celle qui permet une conduction électrique entre les première et deuxième couches polycristallines (12, 14),
- la formation d'une deuxième couche isolante (15) plus épaisse que la première couche isolante,
- la définition d'îlots de grille (20) par décapage localisé de la deuxième couche isolante et de la deuxième couche polycristalline, en dehors desdits îlots,
- l'implantation ionique des portions faiblement dopées (21, 22) des régions de source et de drain à travers la première couche isolante (13), la première couche polycristalline (12) et la couche isolante de grille (11) en utilisant les îlots de grille comme masque d'implantation,
- le décapage des parties de la première couche isolante (13) situées en dehors des îlots de grille (20),
- un dépôt sur l'ensemble d'une troisième couche polycristalline (23), rendue conductrice par dopage
- la formation d'espaceurs isolants (25) sur les bords des îlots de grille par un dépôt d'une troisième couche isolante suivi d'un décapage anisotrope de l'essentiel de la troisième couche isolante, lesdits espaceurs isolants délimitant à leur pourtour, des îlots de grille élargis (26),
- l'enlèvement par décapage sélectif des parties de la troisième (23) et de la première (12) couche polycristalline exposées en dehors desdits îlots de grille élargis (26), l'implantation ionique des portions fortement dopées (28, 29) des régions de source et de drain, en utilisant lesdits îlots de grille élargis (26) comme masque d'implantation, puis,
- les opérations de finition du dispositif nécessaires pour les prises de contact et l'interconnexion avec les régions actives et avec les grilles des transistors.

2. Procédé selon la revendications 1, caractérisé en ce que des portions additionnelles (21′, 22′) des régions de drain et de source à dopage intermédiaire, sont réalisées par implantation ionique après le dépôt de la troisième couche polycristalline (23) et avant la réalisation des espaceurs isolants (25).

3. Procédé selon l'une des revendications 1 ou 2, caractérisé en ce que l'épaisseur de la première couche isolante (13) est supérieure à 5nm, et de préférence inférieure à 20nm, et l'épaisseur de la deuxième couche isolante (15) est supérieure à 40nm.

4. Procédé selon l'une quelconque des revendications 1 à 3, caractérisé en ce que l'épaisseur de la troisième couche polycristalline (23) est comprise entre 30 et 100nm et de préférence voisine de 50nm.

5. Procédé selon l'une quelconque des revendications 1 à 4, caractérisé en ce que la couche isolante de grille (11) ainsi que les première, deuxième et troisième couches isolantes (13, 15, 25) sont réalisées en oxyde de silicium.

6. Procédé selon l'une quelconque des revendications 1 à 4, caractérisé en ce que la couche isolante de grille (11) ainsi que les première et troisième couches isolantes (13, 25) sont réalisées en oxyde de silicium tandis que la deuxième couche isolante est composée d'une couche d'oxyde de silicium (15a) recouverte d'une couche de nitrure de silicium (15b).

7. Procédé selon l'une des revendications 5 ou 6, caractérisé en ce qu'après la formation des espaceurs isolants (25), l'enlèvement par décapage, sélectif du matériau polycristallin non protégé est prolongé d'une durée déterminée dans des conditions de décapage isotrope, de manière à former des gorges (30, 31) dans les parties non protégées des première et troisième couches polycristallines (12, 23), et en ce que ces gorges sont ensuite comblées avec un matériau isolant particulier ayant des propriétés sélectives de décapage, par les opérations successives de dépôt d'une couche (46) d'un tel matériau et de décapage anisotrope de l'essentiel de cette couche qui est situé en dehors desdites gorges (30, 31).

8. Procédé selon la revendication 7, caractérisé en ce que ledit matériau isolant particulier est du nitrure de silicium, et en ce que la couche (46) déposée de ce matériau isolant a une épaisseur d'environ 100nm.

## Patentansprüche

1. Verfahren zur Herstellung einer Halbleiteranordnung mit mindestens einem MIS-Transistor, der ein Drain-Gebiet und ein Source-Gebiet mit jeweils einem schwach dotierten Abschnitt (21, 22) und einen stark dotierten Abschnitt (28, 29) hat, der geringfügig gegenüber dem vorhergehenden Abschnitt seitlich verschoben ist, sowie eine Gate-Elektrode (12, 14), die den schwach dotierten Abschnitt bedeckt und sich lateral in Richtung des stark dotierten Abschnitt erstreckt, in welchem Verfahren auf einem mit einer isolierenden Gate-Schicht (11) bedeckten Halbleiterkörper (10) nacheinander folgendes realisiert wird:
- Abscheidung einer ersten durch Dotieren leitend gemachten polykristallinen Schicht (12),
- die Bildung einer dünnen, ersten Isolierschicht (13), im Hinblick auf spätere Verwendung als Ätzstoppschicht,
- Abscheidung einer zweiten leitenden polykristallinen Schicht (14), die dicker als die erste polykristalline Schicht ist, wobei die erste Isolierschicht (13) eine größere Dicke hat als die, die eine elektrische Leitung zwischen der ersten und der zweiten polykristallinen Schicht (12, 14) zuläßt,
- die Bildung einer zweiten Isolierschicht (13), die dicker als die erste Isolierschicht ist,
- die Definition von Gate-Inseln (20) durch lokales Ätzen der zweiten Isolierschicht und der zweiten polykristallinen Schicht außerhalb der genannten Inseln,
- die Ionenimplantation der schwach dotierten Abschnitte (21, 22) der Source- und Drain-Gebiete quer durch die erste Isolierschicht (13), die erste polykristalline Schicht (12) und die isolierende Gate-Schicht (11) unter Verwendung der Gate-Inseln als Implantationsmaske,
- Wegätzen der außerhalb der Gate-Inseln (20) liegenden Teile der ersten Isolierschicht (13),
- Abscheidung auf der Gesamtheit einer dritten, durch Dotieren leitend gemachten polykristallinen Schicht (23),
- die Bildung isolierender Spacer (25) an den Kanten der Gate-Inseln durch eine Abscheidung einer dritten Isolierschicht mit anschließendem anisotropen Ätzen des Hauptteils dieser Isolierschicht, wobei die genannten isolierenden Spacer die erweiterten Gate-Inseln (26) an ihrem äußeren Umfang begrenzen,
- das Entfernen der freigelegten Abschnitte der dritten (23) und der ersten (12) polykristallinen Schicht außerhalb der erweiterten Gate-Inseln (26) durch selektives Ätzen,
- Ionenimplantation der stark dotierten Abschnitte (28, 29) der Source- und Drain-Gebiete, unter Verwendung der genannten erweiterten Gate-Inseln (26) als Implantationsmaske, danach
- die für die Kontaktierungen und die Verdrahtung mit den aktiven Gebieten und den Gates der Transistoren notwendigen Endbearbeitungen der Anordnung.

2. Verfahren nach Anspruch 1, dadurch gekennzeichnet, daß zusätzliche mittelstark dotierte Abschnitte (21′, 22′) der Drain- und Source-Gebiete durch Ionenimplantation nach Abscheidung der dritten polykristallinen Schicht (23) und vor der Realisierung der isolierenden Spacer (25) realisiert werden.

3. Verfahren nach Anspruch 1 oder 2, dadurch gekennzeichnet, daß die Dicke der ersten Isolierschicht größer als 5 nm ist und vorzugsweise kleiner als 20 nm und die Dicke der zweiten Isolierschicht (15) größer 40 nm ist.

4. Verfahren nach einem der Ansprüche 1 bis 3, dadurch gekennzeichnet, daß die Dicke der dritten polykristallinen Schicht (23) zwischen 30 und 100 nm liegt und vorzugsweise nahe 50 nm.

5. Verfahren nach einem der Ansprüche 1 bis 4, dadurch gekennzeichnet, daß die isolierende Gate-Schicht (11) sowie die erste, zweite und dritte Isolierschicht (13,15, 25) aus Siliciumoxid sind.

6. Verfahren nach einem der Ansprüche 1 bis 4, dadurch gekennzeichnet, daß die isolierende Gate-Schicht (11) sowie die erste und dritte Isolierschicht (13, 25) aus Siliciumoxid sind, während die zweite Isolierschicht aus einer mit einer Siliciumnitridschicht (15b) bedeckten Siliciumoxidschicht (15a) besteht.

7. Verfahren nach einem der Ansprüche 5 oder 6, dadurch gekennzeichnet, daß nach Bildung der isolierenden Spacer (25) das Entfernen von nicht geschütztem polykristallinem Material durch selektives Ätzen während einer bestimmten Dauer unter isotropen Ätzbedingungen verlängert wird, um in den nicht geschützten Teilen der ersten und der dritten polykristallinen Schicht (12, 23) Gräben zu bilden und daß diese Gräben anschließend mit speziellem isolierendem Material aufgefüllt werden, das selektive Ätzeigenschaften hat, durch aufeinanderfolgende Operationen zur Abscheidung einer Schicht (46) eines solchen Materials und anisotropes Ätzen des Hauptteils dieser Schicht, der außerhalb der genannten Gräben (30, 31) liegt.

8. Verfahren nach Anspruch 7, dadurch gekennzeichnet, daß das genannte spezielle isolierende Material aus Siliciumnitrid ist und daß die abgeschiedene Schicht aus diesem isolierenden Material eine Dicke von ungefähr 100 nm hat.

## Claims

1. A process for manufacturing a semiconductor device comprising at least one transistor of the MIS type having a drain region and a source region each comprising a weakly doped portion (21,22) and a highly doped portion (28,29) slightly offset laterally with respect to the former portion, as well as a gate electrode (12,14) covering the weakly doped portion and extending laterally to the highly doped portion, which process successively effects on a semiconductor body covered by an insulating gate layer (11):
- a deposition of a first polycrystalline layer (12) rendered conducting by doping,
- the formation of a first, thin insulating layer (13) for later use as an etching stopper,
- a deposition of a second polycrystalline conducting layer (14) which is thicker than the first polycrystalline layer the first insulating layer (13) having a thickness exceeding that which permits of obtaining an electrical conduction between the first and second polycrystalline layers (12,14),
- the formation of a second insulating layer (15) which is thicker than the first insulating layer,
- the definition of gate islands (20) by local etching of the second insulating layer and of the second polycrystalline layer outside said islands,
- ion implantation of the weakly doped portions (21,22) of the source and drain regions through the first insulating layer (13), the first polycrystalline layer (12) and the insulating gate layer (11) whilst using the gate islands as an implantation mask,
- the removal by etching of the portions of the first insulating layer (13) situated outside the gate islands (20),
- the deposition on the assembly of a third polycrystalline layer (23) which is rendered conducting by doping,
- the formation of insulating spacers (25) on the edges of the gate islands by deposition of a third insulating layer followed by anisotropic etching of the major portion of this layer, said insulating spacers limiting widened gate islands (26) at their periphery,
- the removal by selective etching of portions of the third (23) and of the first (12) polycrystalline layer exposed outside said widened gate islands (26),
- ion implantation of the highly doped portions (28,29) of the source and drain regions whilst using said widened gate islands (26) as an implantation mask, and subsequently
- the operations of finishing the device necessary for providing the contact connections and the interconnections with the active regions and with the gates of the transistors.

2. A process as claimed in Claim 1, characterized in that additional portions (21′,22′) of the drain and source regions having an intermediate doping are formed by ion implantation after the deposition of the third polycrystalline layer (23) and before the formation of the insulating spacers (25).

3. A process as claimed in one of the Claims 1 or 2, characterized in that the thickness of the first insulating layer (13) is greater than 5 nm, and preferably below 20 nm, and the thickness of the second insulating layer (15) is greater than 40 nm.

4. A process as claimed in any one of the Claims 1 to 3, characterized in that the thickness of the third polycrystalline layer (23) lies between 30 and 100 nm and is preferably approximately 50 nm.

5. A process as claimed in any one of the Claims 1 to 4, characterized in that the insulating gate layer (11) and the first, second and third insulating layers (13,15,25) are formed from silicon oxide.

6. A process as claimed in any one of the Claims 1 to 4, characterized in that the insulating gate layer (11) and the first and third insulating layers (13,25) are formed from silicon oxide, while the second insulating layer is composed of a silicon oxide layer (15a) covered by a silicon nitride layer (15b).

7. A process as claimed in one of the Claims 5 or 6, characterized in that, after the formation of the insulating spacers (25), the removal by selective etching of the unprotected polycrystalline material is prolonged for a given duration in isotropic etching conditions so as to form grooves (30,31) in the unprotected portions of the first and third polycrystalline layers (12,23), and in that these grooves are then filled with a particular insulating material which has selective etching properties by the successive operations of depositing a layer (46) of such a material and of anisotropically etching the major portion of this layer which is situated outside said grooves (30,31).

8. A process as claimed in Claim 7, characterized in that said particular insulating material is silicon nitride, and in that the deposited layer (46) of this insulating material has a thickness of approximately 100 nm.
